# EUROPÄISCHE PATENTSCHRIFT

(11) **EP 0 313 129 B1**
(45) Veröffentlichungstag und Bekanntmachung des Hinweises auf die Patenterteilung: **26.01.1994**
(21) Anmeldenummer: 88202191.8
(22) Anmeldetag: 04.10.1988
(51) Int. Cl.: H03L 7/14

(54) **Phasenregelkreis mit einem spannungsgesteuerten Oszillator**
Phase-locked loop with a voltage-controlled oscillator
Boucle d'asservissement de phase avec un oscillateur commandé en tension

(30) Priorität: 17.10.1987 DE 3735188
(43) Veröffentlichungstag der Anmeldung: 26.04.1989
(73) Patentinhaber: Philips Patentverwaltung GmbH, 22335 Hamburg (DE); Philips Electronics N.V., 5621 BA Eindhoven (NL)
(72) Erfinder: Schroth, Volkmar, Dipl.-Ing., D-8500 Nürnberg 10 (DE); Levin, Horst, Dipl.-Ing., D-8560 Lauf (DE)
(74) Vertreter: Peuckert, Hermann, Dipl.-Ing.

(56) Entgegenhaltungen:
- EP-A- 0 181 439
- PATENT ABSTRACTS OF JAPAN, Band 4, Nr. 14 (E-169), 31. Januar 1980, Seite 83 E 169; & JP-A-54 154 248 (FUJITSU K.K.) 12-05-1979
- PATENT ABSTRACTS OF JAPAN, Band 9, Nr. 325 (E-368)[2048], 20. Dezember 1985; & JP-A-60 158 724 (NIPPON DENKI K.K.) 20-08-1985

## Beschreibung

Die Erfindung betrifft einen Phasenregelkreis mit einem spannungsgesteuerten Oszillator und mit einer Ersatztaktumschaltung, die bei Ausfall der Führungsgröße den Regelkreis unterbricht und den spannungsgesteuerten Oszillator mit einer nominell zeitlich konstanten Steuerspannung weiterlaufen läßt. Ein derartiger Phasenregelkreis ist z.B. aus der DE-A-33 24 919 und der DE-A-34 41 226 und EP-A-0 181 439 bekannt.

Bei einem Phasenregelkreis nach der DE-A-33 24 919 umfaßt die Ersatztaktumschaltung einen Taktgenerator sehr hoher Frequenz verglichen mit der Referenzfrequenz (Führungsgröße) des Regelkreises, einen Blockierkreis zur Überwachung der Referenzfrequenz, einen Vorwärts-Rückwärts-Zähler und eine Schaltmatrix. Trotz dieses Bauteileaufwandes kann bei schnell regelnden Regelkreisen der Fall eintreten, daß der spannungsgesteuerte Oszillator mit einer Frequenz weiterläuft, die erheblich von der Frequenz abweicht, die er vor Ausfall der Referenzfrequenz abgegeben hat. Zur Verbesserung eines solchen Regelkreises wird die Ersatztaktschaltung nach der DE-A-34 41 226 um ein Rechenwerk, einen Integrator und einen Schwellwertdetektor erweitert. Unter Ersatztaktumschaltung werden hier sämtliche Bausteine eines Phasenregelkreises verstanden, die nötig sind, um den spannungsgesteuerten Oszillator nach Ausfall der Führungsgröße (Referenzfrequenz) weiterlaufen zu lassen.

Der Erfindung liegt die Aufgabe zugrunde, einen Phasenregelkreis der eingangs genannten Art anzugeben, dessen Ersatztaktumschaltung weniger aufwendig ist, und dessen spannungsgesteuerter Oszillator nach Ausfall der Referenzfrequenz unter Umständen auch über Wochen mit praktisch unveränderter Frequenz weiterlaufen kann.

Diese Aufgabe wird bei einem Phasenregelkreis der eingangs genannten Art dadurch gelöst, daß es sich bei der Steuerspannung um eine Spannung handelt, bei der der Oszillator eine Schwingung vorherbestimmter Frequenz abgibt, und daß die Ersatztaktumschaltung die Kennlinie des spannungsgesteuerten Oszillators so verändert, daß eine Steuerspannungsänderung zu geringerer Frequenzänderung führt als im Normalbetrieb.

Vorteilhafte Ausgestaltungen der Erfindung sind in den Unteransprüchen angegeben.

Anhand eines Ausführungsbeispieles, das in den Figuren dargestellt ist, soll die Erfindung näher erläutert werden.

Es zeigen:
Figur 1 einen Ausschnitt aus einem Phasenregelkreis mit den wesentlichen Bestandteilen einer erfindungsgemäßen Ersatztaktumschaltung und
Figur 2 einen Sollspannungsgeber.

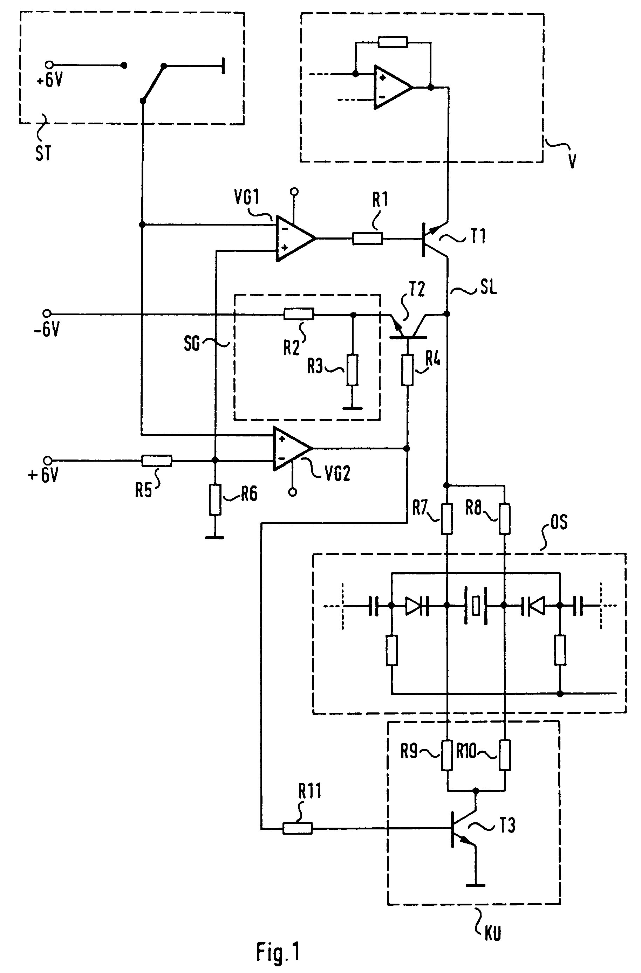

In Figur 1 sind nur die für die Erläuterung der Erfindung wesentlichen Bausteine eines Phasenregelkreises abgebildet. Zu diesen Bausteinen gehört ein Verstärker V, der die Stellspannung (Stellgröße) des Regelkreises verstärkt, und ein nachgeschalteter spannungsgesteuerter Oszillator OS. Details des Verstärkers V und des Oszillators OS sind nur angedeutet. Ebenfalls nur andeutungsweise abgebildet ist eine Einheit ST. Sie enthält einen steuerbaren Umschalter und eine Überwachungsschaltung, die den Umschalter in Abhängigkeit vom Pegel der Referenzfrequenz des Phasenregelkreises steuert. Die Einheit ST mit dem steuerbaren Umschalter und der Überwachungsschaltung sind Bestandteile der Ersatztaktumschaltung, deren Details für die Erfindung von untergeordneter Bedeutung sind.

In einer Ader der Steuereingangsleitung SL für den Oszillator OS liegt ein steuerbarer Schalter T1, der im Ausführungsbeispiel durch einen npn-Transistor T1 realisiert ist. Die andere Ader der Steuereingangsleitung SL ist auf Bezugspotential gelegt.

Der Verbindungspunkt zwischen dem Kollektor des Transistors T1 und dem Oszillator OS ist über einen zweiten steuerbaren Schalter - ebenfalls durch einen npn-Transistor T2 realisiert - mit einer Ausgangsader eines Sollspannungsgebers SG verbunden, dessen eine Eingangsader gegenüber einem Punkt mit Bezugspotential eine Spannung von -6 V führt. In seiner einfachsten Ausführungsform ist der Sollspannungsgeber SG ein ohmscher Spannungsteiler R2, R3, dessen Mittenabgriff mit dem Emitter des Transistors T2 verbunden ist.

Die Basen der beiden Transistoren T1 und T2 werden jeweils über einen Basiswiderstand R1 bzw. R4 von je einem Vergleicher VG1 bzw. VG2 angesteuert. Die beiden Vergleicher VG1 und VG2 sind vom Aufbau her identisch. Ihre Eingänge sind so mit dem Mittenabgriff eines Spannungsteilers R5, R6 und dem Ausgang der Einheit ST verbunden, daß sie nur mit entgegengesetzt gleicher Eingangsspannung angesteuert werden; daher können sie auch nur entgegengesetzte Schaltzustände annehmen.

Die Eingangsspannung des Spannungsteilers R5, R6 beträgt +6 V. Der Transistor T1 ist also dann leitend, wenn der Transistor T2 gesperrt ist und umgekehrt.

Befindet sich die Phasenregelschleife im Normalbetrieb, ist über den steuerbaren Umschalter der Einheit ST Bezugspotential - d.h. null Volt - an den invertierenden Eingang des Vergleichers VG1 und an den nichtinvertierenden Eingang des Vergleichers VG2 gelegt; der Transistor T1 ist dann geöffnet und der Transistor T2 gesperrt. Fällt die Referenzfrequenz aus, wird über den steuerbaren Umschalter statt des Bezugspotentials eine Spannung von +6 V an die gleichen Eingänge der Vergleicher VG1 und VG2 gelegt. Der Transistor T1 ist dann gesperrt, der Transistor T2 dagegen geöffnet.

Mit dem Durchschalten des Transistors T2 wird die Ausgangsspannung des Sollspannungsgebers SG an den Eingang des Oszillators OS gelegt. Durch Bemessung der Widerstände R2 und R3 kann diese Spannung so gewählt werden, daß der Oszillator OS mit der vorherbestimmten Frequenz schwingt. Damit diese Frequenz sich möglichst wenig im Laufe der Zeit ändert, in der die Ersatztaktschaltung wirksam ist, wird mit dem Durchschalten des Transistors T2 gleichzeitig die Empfindlichkeit des spannungsgesteuerten Oszillators OS - durch das Wirksamschalten zweier Spannungsteiler R7, R9 und R8, R10 an seinem Eingang - herabgesetzt. Das Wirksamschalten erfolgt durch einen npn-Transistor T3, der über einen Widerstand R11 mit dem Ausgang des Vergleichers VG2 verbunden ist. Wegen der speziellen Variante des spannungsgesteuerten Oszillators OS sind hier zwei Spannungsteiler an seinem Eingang vorgesehen.

Meistens hat ein spannungsgesteuerter Oszillator ohnehin einen Eingangswiderstand, der als Längswiderstand des Spannungsteilers zur Herabsetzung der Empfindlichkeit verwendet werden kann, so daß die gesamte Einrichtung zur Kennlinienumschaltung (Änderung der Empfindlichkeit) KU nur aus einem bzw. zwei Querwiderständen besteht, die bei Einschalten des Transistors T3 die Spannungs-Frequenz-Gerade des Oszillators OS flacher werden lassen.

Da die Ersatztaktumschaltung unter Umständen mehrere Wochen eingeschaltet bleiben muß, ist es günstig, die Temperaturabhängigkeit der Ausgangsfrequenz des spannungsgesteuerten Oszillators OS durch eine besondere Ausgestaltung des Sollspannungsgebers SG zu kompensieren.

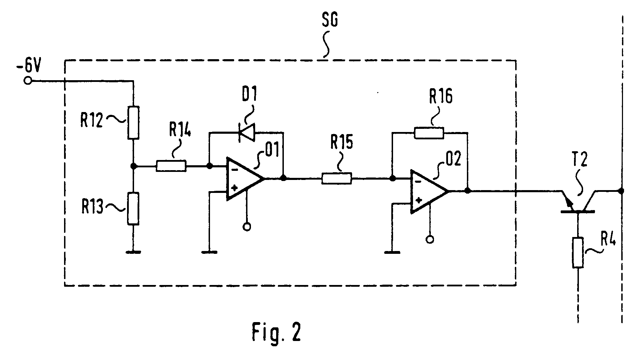

Diese Ausgestaltung ist in Figur 2 gezeigt. Der Mittenabgriff eines Spannungsteilers R12, R13, der die gleiche Funktion hat wie der Spannungsteiler R2, R3 in Figur 1, ist über einen Widerstand R14 mit dem invertierenden Eingang eines Operationsverstärkers O1 verbunden. Der Operationsverstärker O1 ist über eine Diode D1 gegengekoppelt. Sein Ausgang wiederum ist über einen Widerstand R15 mit dem invertierenden Eingang eines weiteren, über einen Widerstand R16 gegengekoppelten Operationsverstärker O2 verbunden. Die nicht invertierenden Eingänge der Operationsverstärker sind auf Bezugspotential gelegt. Der Ausgang des Operationsverstärkers O2 ist an den Emitter des Transistors T2 geführt.

Die Temperaturabhängigkeit der Parameter der Diode D1 sorgt für eine Temperaturabhängigkeit der Eingangsspannung des spannungsgesteuerten Oszillators OS bei eingeschalteter Ersatztaktumschaltung. Durch diese Temperaturabhängigkeit werden die Temperaturschwankungen der Ausgangsfrequenz des spannungsgesteuerten Oszillators OS ausgeglichen.

## Patentansprüche

1. Phasenregelkreis mit einem spannungsgesteuerten Oszillator (OS) und mit einer Ersatztaktumschaltung, die bei Ausfall der Führungsgröße den Regelkreis unterbricht und den spannungsgesteuerten Oszillator mit einer nominell zeitlich konstanten Steuerspannung weiterlaufen läßt,
dadurch gekennzeichnet,
daß es sich bei der Steuerspannung um eine Spannung handelt, bei der der Oszillator (OS) eine Schwingung vorherbestimmter Frequenz abgibt, und
daß die Ersatztaktumschaltung die Kennlinie des spannungsgesteuerten Oszillators (OS) so verändert, daß eine Steuerspannungsänderung zu geringerer Frequenzänderung führt als im Normalbetrieb.

2. Phasenregelkreis nach Anspruch 1,
dadurch gekennzeichnet,
daß die Ersatztaktumschaltung einen ersten steuerbaren Schalter (T1) in der Steuereingangsleitung (SL) des spannungsgesteuerten Oszillators (OS) umfaßt, durch den die Steuereingangsleitung (SL) unterbrochen wird, und daß gleichzeitig über einen zweiten steuerbaren Schalter (T2) der Ausgang eines von einer Gleichspannungsquelle gespeisten Sollspannungsgebers (SG) mit dem Steuereingang des spannungsgesteuerten Oszillators (OS) verbunden wird.

3. Phasenregelkreis nach Anspruch 2,
dadurch gekennzeichnet,
daß es sich bei dem Sollspannungsgeber (SG) um einen ersten Spannungsteiler (R2, R3) mit ohmschen Widerständen handelt.

4. Phasenregelkreis nach Anspruch 2 oder 3,
dadurch gekennzeichnet,
daß zur Ansteuerung der beiden steuerbaren Schalter jeweils ein Komparator (VG1, VG2) vorgesehen ist, dessen Ausgang über einen Widerstand (R1, R4) mit dem Steuereingang des zugehörigen Schalters (T1, T2) verbunden ist, daß die Eingänge der Komparatoren (VG1, VG2) so beschaltet sind, daß sie nur entgegengesetzte Schaltzustände annehmen können, und daß durch die Stellung eines steuerbaren Umschalters (ST) festgelegt wird, welchen ihrer beiden Schaltzustände die Komparatoren (VG1, VG2) einnehmen.

5. Phasenregelkreis nach Anspruch 4,
dadurch gekennzeichnet,
daß einer der Komparatoren (VG2) über einen Widerstand (R11) mit dem Steuereingang eines dritten steuerbaren Schalters (T3) verbunden ist, mit dem bei der Unterbrechnung der Steuereingangsleitung (SL) ein am Steuereingang des spannungsgesteuerten Oszillators (OS) gelegener zweiter Spannungsteiler (R7, R9) wirksam geschaltet wird.

6. Phasenregelkreis nach Anspruch 3, 4 oder 5,
dadurch gekennzeichnet,
daß zur Kompensation der Temperaturabhängigkeit der Kennlinien des spannungsgesteuerten Oszillators (OS) zwischen dem Mittenabgriff des ersten Spannungsteilers (R12, R13) und dem zweiten steuerbaren Schalter (T2) eine Kettenschaltung gegengekoppelter Operationsverstärker (O1, O2) liegt, von denen mindestens einer einen temperaturabhängigen Widerstand (D1) im Rückkopplungszweig enthält.

## Claims

1. Phase control loop with a voltage-controlled oscillator (OS) ad a substitution clock changing circuit, that interrupts the control loop in case the reference signal fails, and allows the voltage-controlled oscillator to proceed with a nominal unvarying control voltage, characterized in that when reference is made to the control voltage, a voltage is meant at which the oscillator (OS) produces a oscillation of a preset frequency, and in that the substitution clock changing circuit changes the characteristic of the voltage-controlled oscillator (OS) to such an extent that a change of the control voltage leads to a smaller change of frequency than in normal operating conditions.

2. Phase control loop as claimed in Claim 1, characterized in that the substitution clock changing circuit comprises a first controllable switch (T1) in the control input line (SL) of the voltage-controlled oscillator (OS), for interrupting the control input line (SL), and in that, simultaneously, through a second controllable switch (T2) the output of a nominal voltage generator (SG) supplied by a DC voltage source is connected to the control input of the voltage-controlled oscillator (OS).

3. Phase control loop as claimed in Claim 2, characterized in that a first voltage divider (R2, R3) with ohmic resistors is meant when the nominal voltage generator (SG) is concerned.

4. Phase control loop as claimed in Claim 2 or 3, characterized in that for activating the two controllable switches one comparator each (VG1, VG2) is provided, whose output is connected through a respective resistor (R1, R4) to the control input of the associated switch (T1, T2), in that the inputs of the comparators (VG1, VG2) are switched such that they can assume only opposite switch positions, and in that the position of a controllable change-over switch (ST) determines which one of their two switch positions the comparators (VG1, VG2) assume.

5. Phase control loop as claimed in Claim 4, characterized in that one of the comparators (VG2) is connected to the control input of a third controllable switch (T3) through a resistor (R11), so that when the control input line (SL) is interrupted, a second voltage divider (R7, R9) located at the control input of the voltage-controlled oscillator (OS) is activated.

6. Phase control loop as claimed in Claim 3, 4 or 5, characterized in that between the middle tap of the first voltage divider (R12, R13) and the second controllable switch (T2) a network of feedback operational amplifiers (01, 02) is located, of which at least one comprises a temperature-dependent resistor (D1) in the feedback branch to compensate the temperature-dependence of the characteristics of the voltage-controlled oscillator (OS).

## Revendications

1. Boucle d'asservissement de phase avec un oscillateur commandé en tension (OS) et avec un circuit de cadence de substitution, qui interrompt la boucle d'asservissement lorsqu'il y a défaillance de la grandeur de commande et continue à faire fonctionner l'oscillateur commandé en tension avec une tension de commande nominale constante dans le temps, caractérisée en ce que la tension de commande est en fait une tension pour laquelle l'oscillateur (OS) délivre une oscillation de fréquence prédéterminée et le circuit de cadence de substitution modifie la caractéristique de l'oscillateur commandé en tension (OS) de sorte qu'une modification de la tension de commande mène à une modification de fréquence moindre qu'en exploitation normale.

2. Boucle d'asservissement de phase selon la revendication 1, caractérisée en ce que le circuit de cadence de substitution comprend un premier commutateur actionnable (T1) dans la ligne d'entrée de commande (SL) de l'oscillateur commandé en tension (OS), commutateur par lequel la ligne d'entrée de commande (SL) est interrompue, et, simultanément, via un second commutateur actionnable (T2), la sortie d'un indicateur de tension de consigne (SG) alimenté par une source de tension continue est reliée à l'entrée de commande de l'oscillateur commandé en tension (OS).

3. Boucle d'asservissement de phase selon la revendication 2, caractérisée en ce que l'indicateur de tension de consigne (SG) est constitué en fait d'un premier diviseur de tension (R2, R3) avec des résistances ohmiques.

4. Boucle d'asservissement de phase selon la revendication 2 ou 3, caractérisée en ce que, pour commander les deux commutateurs actionnables, il est prévu respectivement un comparateur (VG1, VG2) dont la sortie est reliée via une résistance (R1, R4) à l'entrée de commande du commutateur correspondant (T1, T2), les entrées des comparateurs (VG1, VG2) sont commutées, de telle sorte qu'ils ne puissent adopter que des positions de commutation opposées et la position d'un commutateur actionnable (ST) permet d'établir lesquelles de leurs deux positions de commutation les commutateurs (VG1, VG2) adopteront.

5. Boucle d'asservissement de phase selon la revendication 4, caractérisée en ce qu'un des comparateurs (VG2) est relié via une résistance (R11) à l'entrée de commande d'un troisième commutateur actionnable (T3) avec lequel, lors de l'interruption de la ligne d'entrée de commande (SL), un second diviseur de tension (R7, R9) placé à l'entrée de commande de l'oscillateur commandé en tension (OS) est connecté pour être activé.

6. Boucle d'asservissement de phase selon la revendication 3, 4 ou 5, caractérisée en ce que, pour compenser la dépendance vis-à-vis de la température des caractéristiques de l'oscillateur commandé en tension (OS), on place entre la prise centrale du premier diviseur de tension (R12, R13) et le second commutateur actionnable (T2) un réseau récurrent d'amplificateurs opérationnels contrecouplés (O1, O2) dont au moins un contient une résistance (D1) dépendant de la température dans la branche de contrecouplage.
